(19) Europäisches Patentamt
European Patent Office
Office européen des brevets

(11) Numéro de publication : **0 309 305 B1**

(12) **FASCICULE DE BREVET EUROPEEN**

(45) Date de publication du fascicule du brevet :
06.05.92 Bulletin 92/19

(51) Int. Cl.[5] : **G03F 9/00**, G01D 5/38

(21) Numéro de dépôt : **88402229.4**

(22) Date de dépôt : **05.09.88**

(54) **Système pour le positionnement rigoureux d'un objet le long d'un axe.**

(30) Priorité : **08.09.87 FR 8712435**

(43) Date de publication de la demande :
**29.03.89 Bulletin 89/13**

(45) Mention de la délivrance du brevet :
**06.05.92 Bulletin 92/19**

(84) Etats contractants désignés :
**AT BE CH DE ES GB GR IT LI LU NL SE**

(56) Documents cités :
**MICROCIRCUIT ENGINEERING 80, Proceedings of the International Conference on
Microlithography, 30 septembre - 2 octobre
1980,Amsterdam, édité par R.P. KRAMER,
pages 181-191, Delft University Press; G.
DUBROEUCQ et al.: "Double diffraction gratings as keysfor high contrast alignment on
wafer steppers"**

(56) Documents cités :
**SOLID STATE TECHNOLOGY, juin 1980, pages
80-84; S. WITTEKOEK: "Step-and-repeat
wafer imaging"
J. VAC. SCI. TECHNOL., vol. 19, no. 4, novem-
bre/décembre 1981, pages 1214-1218, American Vacuum Society; T.M. LYSZCZARZ etal.:
"Experimental evaluation of interferometric
alignment techniques for multiple mask registration"**

(73) Titulaire : **MICRO-CONTROLE, Société
Anonyme dite:
Z.I. de St. Guénault
F-91005 Evry (FR)**

(72) Inventeur : **Berger, Laurent
16, rue des Chênes
F-91540 Mennecy (FR)**

(74) Mandataire : **Bonnetat, Christian et al
CABINET BONNETAT 23, Rue de Léningrad
F-75008 Paris (FR)**

EP 0 309 305 B1

## Description

La présente invention concerne un dispositif pour le positionnement rigoureux d'un objet le long d'un axe. Quoique non exclusivement, elle est particulièrement adaptée à être mise en oeuvre dans les machines de fabrication de circuits intégrés, telles que celles appelées "photorépéteurs".

On sait que la fabrication des circuits intégrés s'effectue par étapes successives, auxquelles des zones délimitées d'une plaquette de matière semi-conductrice doivent être soumises à des opérations spécifiques telles que masquage, décapage, métallisation, diffusion, etc... Afin que chacune de ces opérations soit effectuée dans la zone correspondante et non pas dans des zones voisines, il est évidemment très important que le positionnement de ladite plaquette de matière semi-conductrice par rapport à la machine soit rigoureux.

On connaît déjà à cet effet, pour le positionnement rigoureux d'un objet, tel qu'une plaquette de matière semi-conductrice, le long d'un axe, un dispositif comportant :

– un chariot mobile en translation le long dudit axe sous l'action de moyens moteurs commandés, ledit objet étant fixé audit chariot ;

– un premier réseau optique, fixe, linéaire, périodique, parallèle audit axe, constitué de bandes parallèles équidistantes perpendiculaires audit axe ;

– un second réseau optique linéaire, périodique et parallèle audit axe, solidaire dudit objet, également constitué de bandes parallèles équidistantes, ledit objet étant fixé sur ledit chariot de façon que les bandes dudit second réseau optique soient perpendiculaires audit axe et lesdits premier et second réseaux optiques étant au moins approximativement optiquement alignés, lorsque ledit chariot occupe une position d'arrêt déterminée ;

– une source lumineuse pour éclairer ledit premier réseau optique ; et

– un capteur photoélectrique pour capter la lumière provenant desdits premier et second réseaux optiques.

Un tel dispositif, dont le principe est par exemple décrit dans le document MICROCIRCUIT ENGINEERING 80, Proceedings of the International Conference on Microlithography, 30 septembre - 2 octobre 1980, Amsterdam, édité par R.P. Kramer, pages 181-190, Delft University Press ; G. Dubroeucq et al. : "Double diffraction gratings as keys for high contrast alignment on wafer steppers", est destiné au réglage fin du positionnement de l'objet le long dudit axe et est généralement utilisé en combinaison avec un autre système de positionnement (qui ne sera pas décrit, car ne faisant pas partie de la présente invention) permettant un positionnement grossier, notamment pour amener ledit chariot dans une position d'arrêt telle que lesdits premier et second réseaux optiques soient au moins approximativement alignés.

Si, dans cette position d'arrêt dudit chariot, l'objet est rigoureusement positionné par rapport audit axe (c'est-à-dire qu'alors lesdits premier et second réseaux sont exactement alignés) et si, à partir de cette position d'arrêt, on communique au chariot un déplacement le long dudit axe égal à un ou plusieurs pas de répartition desdites bandes des réseaux, le capteur photoélectrique engendre un signal périodique, qui peut être considéré comme un signal de référence. Ce signal de référence a une fréquence correspondant à l'inverse du pas dudit second réseau.

En revanche, si, dans ladite position d'arrêt dudit chariot, l'objet n'est pas rigoureusement positionné par rapport audit axe (c'est-à-dire qu'alors lesdits premier et second réseaux ne sont pas exactement alignés) et si, à partir de cette position d'arrêt du chariot, on communique au chariot le même déplacement que précédemment, le capteur photoélectrique délivre un signal périodique, semblable audit signal de référence et de même fréquence, mais déphasé par rapport à celui-ci. Ce déphasage est alors représentatif du décalage entre lesdits premier et second réseaux optiques et donc du décalage dudit objet par rapport à sa position exacte.

En conséquence, on pourrait songer à comparer un tel signal de référence au signal réellement délivré par le capteur photoélectrique pour déterminer le décalage dudit objet par rapport à sa position exacte. Cependant, les résultats que l'on obtiendrait ne seraient pas précis, car le signal délivré par le capteur photoélectrique est parasité par des réflexions, des diffractions et des diffusions parasites provenant notamment de l'état de surface de la plaquette semi-conductrice et des réseaux optiques.

La présente invention a pour objet un dispositif du type décrit précédemment et permettant de mettre en oeuvre les remarques ci-dessus, pour positionner rigoureusement un objet.

A cette fin, selon l'invention, le dispositif du type décrit ci-dessus, est remarquable en ce qu'il comporte :

– des moyens de commande des moyens moteurs pour faire effectuer audit chariot, par rapport à ladite position d'arrêt, un déplacement d'acquisition dont l'amplitude est au moins égale au pas dudit second réseau optique, puis pour amener ledit chariot à ladite position d'arrêt ;

– des moyens pour engendrer, au cours dudit déplacement d'acquisition, un signal de référence périodique, de période correspondant au pas dudit second réseau, synchronisé avec le déplacement dudit chariot, de façon à correspondre au signal périodique pur qui serait engendré par ledit capteur photoélectrique lors du déplacement du chariot, dans le cas où, dans ladite position d'arrêt de celui-ci, lesdits premier et second

2

réseaux optiques seraient rigoureusement alignés et où aucune lumière parasite ne se superposerait à ce signal périodique ;

– des moyens de multiplication pour former, à une pluralité d'instants successifs dudit déplacement d'acquisition, le produit des valeurs correspondantes dudit signal périodique de référence et du signal réellement délivré par ledit capteur photoélectrique lors de ce déplacement d'acquisition;

– des moyens de sommation pour sommer sur une durée correspondant au moins au pas dudit second réseau, le signal formé par la succession desdits produits délivrés par lesdits moyens de multiplication ;

– des moyens de calcul pour déterminer, à partir du signal intégré délivré par lesdits moyens de sommation, le décalage éventuel qui existe entre lesdits premier et second réseaux optiques lorsque le chariot est dans sa position d'arrêt ; et

– des moyens de commande des moyens moteurs pour faire effectuer audit chariot, à partir de ladite position d'arrêt, un déplacement de correction dont l'amplitude correspond audit décalage, afin d'amener lesdits premier et second réseaux optiques en rigoureux alignement.

Ainsi, grâce à la corrélation effectuée par le dispositif conforme à l'invention entre ledit signal de référence et le signal délivré par le capteur, la lumière parasite non périodique est éliminée, tout en permettant la détermination du décalage.

On remarquera que le déplacement d'acquisition peut se faire, soit au cours de l'approche de ladite position d'arrêt, soit à partir de cette position d'arrêt.

Il est avantageux que le signal périodique de référence soit sinusoïdal et/ou cosinusoïdal.

Le premier et/ou le second réseau optique peut être du type réseau de transmission, de réflexion, de diffraction, de phase ou d'amplitude.

Dans un mode de réalisation, lesdits moyens engendrant ledit signal de référence engendrent à la fois un signal de référence sinusoïdal et le signal de référence cosinusoïdal, et lesdits moyens de multiplication et de sommation forment les deux signaux intégrés correspondant, de sorte que lesdits moyens de calcul déterminent ledit décalage à partir de l'arc tangente du rapport desdits signaux intégrés.

Les figures du dessin annexé feront bien comprendre comment l'invention peut être réalisée.

La figure 1 est le schéma synoptique du dispositif conforme à la présente invention.

Les figures 2 et 3 montrent, en vue de dessus, les deux réseaux optiques.

Les figures 4a à 4f illustrent le processus mis en oeuvre par l'invention.

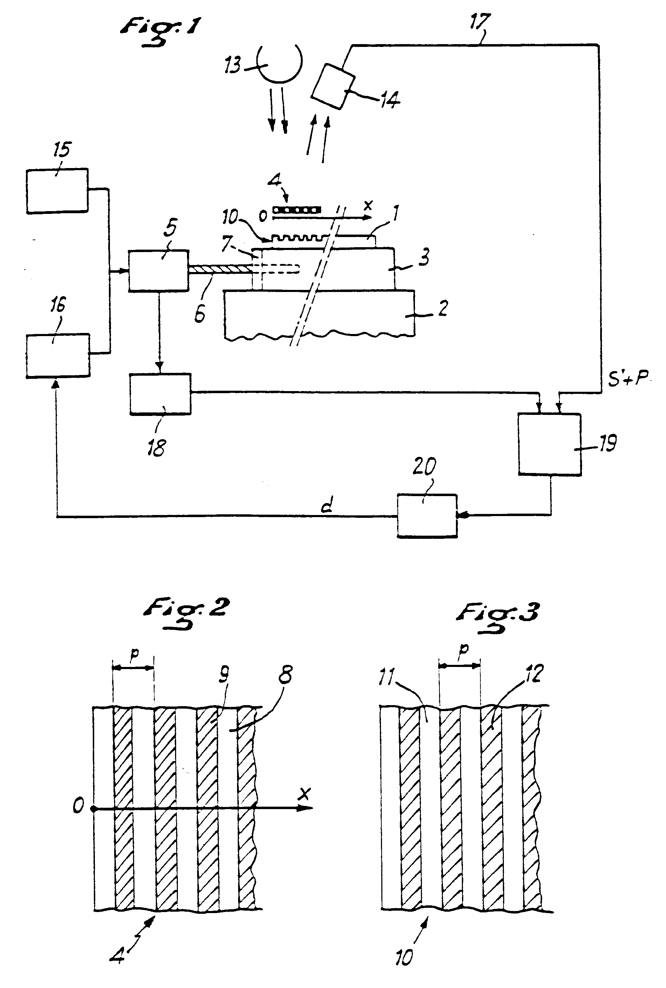

Le dispositif selon l'invention, représenté schématiquement sur la figure 1, est destiné à aligner de façon précise une plaquette semi-conductrice 1 par rapport à un axe fixe OX, lié, ainsi que l'origine O, à une machine de réalisation de circuits intégrés, dont seule une partie du bâti fixe 2, un chariot mobile 3 et un réseau optique fixe 4 sont représentés. Le chariot 3 peut coulisser parallèlement à l'axe OX, sous l'action d'un dispositif d'actionnement comprenant, par exemple, un moteur électrique pas-à-pas 5 entraînant en rotation une vis sans fin 6, engagée dans un écrou 7 solidaire du chariot 3. Ce chariot 3 est supporté par le bâti fixe 2 et est guidé en translation par tous moyens connus, non représentés.

Comme on peut le voir sur la figure 2, le réseau optique 4 comporte au moins des bandes transparentes 8 et des bandes opaques 9, parallèles et alternées, dont le pas de répartition est égal à p. Les bandes transparentes 8 et les bandes opaques 9 sont perpendiculaires à l'axe OX et, par exemple, présentent la même largeur p/2.

Sur la plaquette semi-conductrice 1, est également prévu un réseau optique 10. Ce réseau optique 10 est par exemple réalisé par un ensemble de nervures 11 et de rainures 12, directement gravées dans ladite plaquette semi-conductrice 1. Par suite de leur différence de niveau dans ladite plaquette, lorsque celle-ci est éclairée, lesdites nervures 11 se présentent comme des traits clairs, alors que les rainures 12 se comportent comme des traits sombres. Les nervures 11 et les rainures 12 sont parallèles et alternées et leur pas de répartition est égal au pas p de répartition des bandes 8 et 9 du réseau optique 4. Leurs largeurs sont par exemple égales entre elles et donc égales à p/2.

De plus, grâce à un dispositif de positionnement, non représenté et ne faisant pas partie de la présente invention, la plaquette semi-conductrice est orientée, et fixée en position, sur le chariot 3, de façon que les nervures 11 et les rainures 12 soient perpendiculaires à l'axe OX.

Lorsque le chariot 3 est amené dans un position d'arrêt prédéterminée par des moyens également non représentés, les réseaux 4 et 10 sont au moins approximativement superposés et une source lumineuse 13 éclaire les réseaux 4 et 10. Un capteur photoélectrique 14 reçoit la lumière renvoyée par le réseau 10, après traversée du réseau 4. Sur la figure 1, on a supposé que cette lumière reçue par le capteur 14 était la lumière réfléchie par le réseau 10. Il pourrait également s'agir de lumière diffractée. De plus, si le réseau 10 était transparent, la lumière adressée au capteur 14 pourrait être celle traversant consécutivement les deux réseaux 4 et 10.

Le moteur 5 peut être commandé, soit par un dispositif 15 de commande de balayage, soit par un dispositif 16 de commande de correction de désalignement.

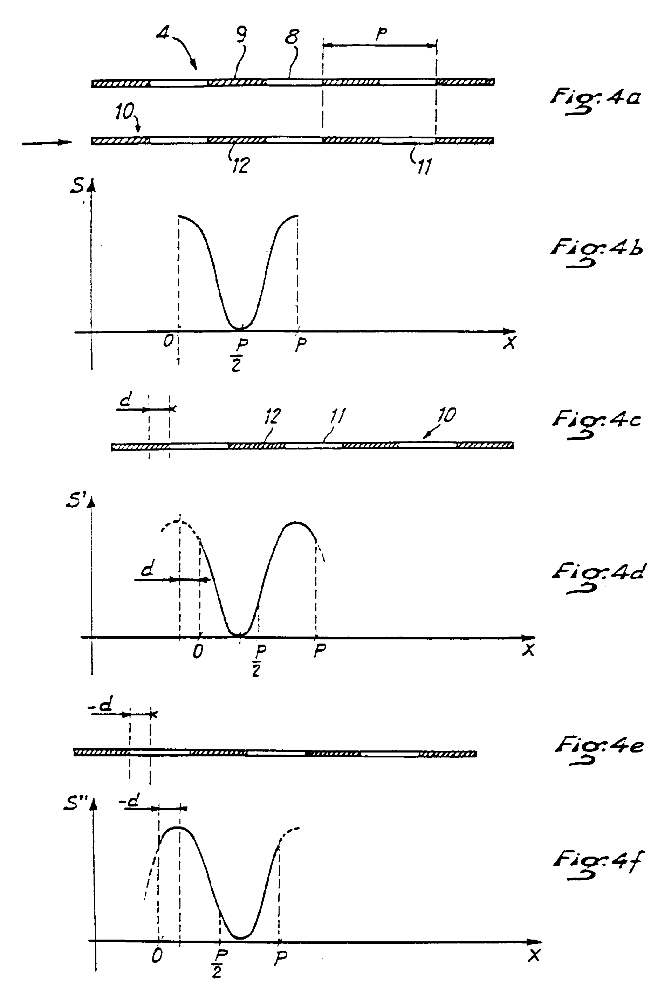

Sur la figure 4a, on a représenté une position d'alignement rigoureux de la plaquette semi-conductrice 1 par rapport au réseau fixe 4, lorsque ledit chariot est dans une position d'arrêt prédéterminée. Dans le cas représenté, les nervures 11 du réseau 10 sont rigoureusement à l'aplomb des bandes transparentes 8 du réseau 4 ; de-même, les rainures 12 du réseau 10 sont rigoureusement à l'aplomb des bandes opaques 9 du réseau 4.

Si, à partir de cette position d'arrêt du chariot 3 correspondant à l'alignement rigoureux représenté sur la figure 4a, le dispositif de commande 15 actionne le moteur 5 pour que celui-ci déplace le chariot 3, parallèlement à OX, d'une distance égale à kp (avec k = 1,2,3...) et si aucune lumière parasite n'existe, le lumière reçue par le capteur 14 varie de façon sinusoïdale, du fait du défilement des nervures 11 et des rainures 12 par rapport aux bandes transparentes 8 et aux bandes opaques 9. Par suite, le signal électrique 5 apparaissant si la sortie 17 du capteur 14 et une fonction sinusoïdale de fréquence $\frac{1}{p}$, comme cela est représenté sur la figure 4b.

Plus précisément, à cause de la position d'alignement initiale choisie, le signal S est une fonction du type S = $S_1 \cos \frac{2\pi}{p} x$, expression dans laquelle x désigne les abcisses le long de l'axe OX et S1 est une constante.

Si maintenant, comme cela est illustré sur la figure 4c, le réseau 10, c'est-à-dire la plaquette semi-conductrice 1, est, dans la position d'arrêt du chariot 3, décalée d'une distances d vers la droite des figures par rapport au réseau 4 et si le dispositif 15 actionne le moteur 5 pour que celui-ci déplace le chariot 3 dans des conditions analogues aux précédentes, on comprend aisément que le signal S′ délivré par le capteur photoélectrique 14 à sa sortie 17 (dans l'hypothèse où il n'y a pas de lumière parasite) devient S′ = $S_1 \cos \frac{2\pi}{p} (x - d)$. Comme cela est représenté sur la figure 4b.

De même, si comme cela est illustré par la figure 4e, le réseau 10 est, dans la position d'arrêt initial du chariot 3, décalé d'une distance d vers la gauche des figures, le signal S devient S″ = $S_1 \cos \frac{2\pi}{p} (x + d)$, à condition toujours qu'il n'y ait aucune lumière parasite.

On voit donc que le déphasage des signaux S′ et S″ (purement périodique) par rapport au signal S (également purement périodique) est représentatif du mésalignement du réseau 10 par rapport au réseau 4, dans la position d'arrêt du chariot, et donc ce déphasage est représentatif du décalage de la plaquette semi-conductrice 1 par rapport à sa position correcte.

On remarquera que, sur la figure 4a, on a supposé que l'alignement correct correspondait à la superposition des bandes transparentes 8 et des bandes opaques 9 du réseau 4 respectivement avec les bandes claires 11 et les bandes foncées 12 du réseau 10. Par suite, les signaux S, S′ et S″ sont des fonctions sinusoïdales. Il va de soi que, dans cette position d'alignement correct, les bandes transparen tes 8 et les bandes opaques 9 du réseau 4 pourraient être choisies respectivement superposées avec les bandes foncées 12 et claire 11 du réseau 10. Les signaux S,S′ et S″ auraient alors une allure cosinusoïdale.

Toutefois, à cause de l'état de surface de la plaquette semi-conductrice 1 et de la présence des réseaux 4 et 10, il se produit des réflexions et des diffusions parasites, de sorte que, dans la réalité, il est impossible d'obtenir les signaux S,S′ et S″ purement périodiques et donc de déterminer le décalage d. Le capteur 14 délivre à sa sortie lesdits signaux périodiques S,S′ et S″ auxquels est superposé un signal parasite P, qui est une fonction de x. Toutefois, on remarquera que, par sa nature même, ce signal parasite P n'a aucune raison d'être périodique, et encore moins de présenter la fréquence $\frac{1}{p}$ des signaux S,S′ et S″.

La présente invention met cette particularité à profit.

Comme on peut le voir sur la figure 1, le dispositif conforme à l'invention comporte de plus :

– un générateur 18, synchronisé avec le déplacement du chariot 3, et délivrant la fonction $\cos \frac{2\pi}{p} x$, ou la fonction $\sin \frac{2\pi}{p} x$, constituant la partie périodique du du signal S ;

– un échantillonneur-intégrateur 19 recevant la fonction délivrée par le générateur 18 et le signal de sortie du capteur 14 ; et

– un calculateur 20 recevant la sortie de l'échantillonneur-intégrateur 19.

L'échantillonneur-intégrateur 19 effectue l'intégration sur au moins une période p du produit du signal de sortie du capteur 14 par la fonction engendrée par le générateur 18.

Ainsi, dans le cas d'un décalage d, l'échantillonneur-intégrateur 19 calcule la grandeur :

$$C1 = \int_0^p S'\cos\frac{2\pi}{p}x\,dx = \int_0^p S1.\cos\frac{2\pi}{p}(x-d).\cos\frac{2\pi}{p}x\,dx + \int_0^p P.\cos\frac{2\pi}{p}x\,dx$$

Puisque la fonction P n'est pas périodique, le deuxième terme de l'équation ci-dessus est nul. Par suite, on obtient :

$$C1 = \int_0^p S1.\cos\frac{2\pi}{p}(x-d).\cos\frac{2\pi}{p}x\,dx = \frac{S1}{2}\cos\frac{2\pi d}{p}$$

A partir de cette expression, le calculateur 20 calcule le décalage $\underline{d}$. Si le générateur 18 délivre de plus la fonction $\sin\frac{2\pi}{p}x$ et si l'échantillonneur intégrateur 19 effectue de plus l'opération

$$C2 = \int_0^p S1\sin\frac{2\pi}{p}x\,dx,$$

cette dernière expression est égale à $\frac{S1}{2}\sin\frac{2\pi d}{p}$

Dans ce cas, le calculateur 20 peut calculer $\underline{d}$ par l'expression :

$$d = \frac{p}{2\pi}\,\text{arc tg}\,\frac{C2}{C1}$$

Le calculateur 20 adresse le décalage calculé $\underline{d}$ au dispositif 16, qui peut corriger la position d'arrêt du chariot 9 par actionnement du moteur 5.

## Revendications

1. Dispositif pour le positionnement rigoureux, le long d'un axe (OX) d'un objet (1), tel qu'une plaquette de matière semi-conductrice au cours d'un processus de fabrication de circuits intégrés, ledit dispositif comportant :
   – un chariot (3) mobile en translation le long dudit axe (OX) sous l'action de moyens moteurs commandés (5), ledit objet (1) étant fixé audit chariot ;
   – un premier réseau optique (4), fixe, linéaire, périodique, parallèle, audit axe, constitué de bandes parallèles équidistantes perpendiculaires audit axe ;
   – un second réseau optique (10) linéaire, périodique et parallèle audit axe, solidaire dudit objet (1), également constitué de bandes parallèles équidistantes, ledit objet (1) étant fixé sur ledit chariot (3) de façon que les bandes dudit second réseau optique (10) soient perpendiculaires audit axe (OX) et lesdits premier et second réseaux optiques étant au moins approximativement optiquement alignés, lorsque ledit chariot occupe une position d'arrêt déterminée ;
   – une source lumineuse (13) pour éclairer lesdits premier et second réseaux optiques (4 et 10) ; et
   – un capteur photoélectrique (14) pour capter la lumière provenant desdits réseaux optiques (4,10),
   caractérisé en ce qu'il comporte :
   – des moyens (15) de commande des moyens moteurs (5) pour faire effectuer audit chariot (3), par rapport à ladite position d'arrêt, un déplacement d'acquisition dont l'amplitude est au moins égale au pas dudit second réseau optique, puis pour amener ledit chariot à ladite position d'arrêt ;
   – des moyens (18) pour engendrer, au cours dudit déplacement d'acquisition, un signal de référence périodique, de période correspondant au pas dudit second réseau, synchronisé avec le déplacement dudit chariot, de façon à correspondre au signal périodique pur qui serait engendré par ledit capteur photoélecrique lors du déplacement du chariot dans le cas où, dans ladite position d'arrêt de celui-ci, lesdits premier et second réseaux optiques seraient rigoureusement alignés et où aucune lumière parasite ne se superposerait à ce signal périodique ;

– des moyens de multiplication (19) pour former, à une pluralité d'instants successifs dudit déplacement d'acquisition, le produit des valeurs correspondantes dudit signal périodique de référence et du signal réellement délivré par ledit capteur photoélectrique lors de ce déplacement d'acquisition ;

– des moyens (19) de sommation pour sommer sur une durée correspondant au moins au pas dudit second réseau, le signal formé par la succession desdits produits délivrés par lesdits moyens de multiplication ;

– des moyens de calcul (20) pour déterminer, à partir du signal intégré délivré par lesdits moyens de sommation, le décalage éventuel qui existe entre lesdits premier et second réseaux optiques lorsque le chariot est dans sa position d'arrêt ; et

– des moyens (16) de commande des moyens moteurs (5) pour faire effectuer audit chariot (3), à partir de ladite position d'arrêt, un déplacement de correction dont l'amplitude correspond audit décalage, afin d'amener lesdits premier et second réseaux optiques en rigoureux alignement.

2. Dispositif selon la revendication 1, caractérisé en ce que ledit signal de référence est sinusoïdal et/ou cosinusoïdal.

3. Dispositif selon la revendication 2, caractérisé en ce que lesdits moyens engendrant ledit signal de référence engendrent à la fois un signal de référence sinusoïdal et un signal de référence cosinusoïdal, et lesdits moyens de multiplication et de sommation forment les deux signaux intégrés correspondants, de sorte que lesdits moyens de calcul déterminent ledit décalage à partir de l'arc tangente du rapport desdits signaux intégrés.

4. Dispositif selon l'une des revendications 1 à 3, caractérisé en ce que lesdits premier et/ou second réseaux optiques sont du type réseaux de transmission, de réflexion ou de diffraction.

5. Dispositif selon l'une des revendications 1 à 3, caractérisé en ce que lesdits premier et/ou second réseaux optiques sont du type réseaux de phase ou d'amplitude.

## Patentansprüche

1. Vorrichtung zur genauen Positionierung eines Objektes (1) wie z.B. eines Wafer aus halbleitendem Material entlang einer Achse (OX) während eines Prozesses zur Herstellung integrierter Schaltungen, welche genannte Vorrichtung

– einen durch gesteuerte Antriebsmittel (5) längs der genannten Achse (OX) translatorisch beweglichen Wagen (3), auf welchem das genannte Objekt (1) befestigt ist,

– ein erstes, feststehendes, lineares, periodisches, zuder genannten Achse paralleles optisches Gitter (4), welches aus parallelen, äquidistanten, zu der genannten Aches senkrechten Streifen besteht,

– ein zweites, mit dem gennanten Objekt (1) fest verbundenes, lineares, periodisches und zu der genannten Achse paralleles optisches Gitter (10), welches ebenfalls aus parallelen, äquidistanten Streifen besteht, wobei das genannte Objekt (1) auf dem genannten Wagen (3) derart befestigt ist, daß die Streifen des genannten zweiten optischen Gitters (10) senkrecht zu der genannten Achse (OX) sind und das genannte erste optische Gitter und das genannte zweite optische Gitter mindestens annähernd optisch zur Deckung gebracht sind, während sich der genannte Wagen in einer bestimmten Haltestellung befindet,

– eine Lichtquelle (13) zur Beleuchtung des genannten ersten optischen Gitters (4) und des genannten zweiten optischen Gitters (10) sowie

– einen photoelektrischen Sensor (14) zur Erfassung des von den genannten optischen Gittern (4 und 10) kommenden Lichtes umfaßt,

dadurch gekennzeichnet, daß sie

– Mittel (15) zur Steuerung der Antriebsmittel (5), um den genannten Wagen (3) gegenüber der genannten Haltestellung eine der Erfassung dienende Bewegung ausführen zu lassen, deren Amplitude mindestens gleich der Teilung des genannten zweiten optischen Gitters ist, und um danach den genannten Wagen in die genannte Haltestellung zu überführen,

– Mittel (18), um während der genannten, der Erfassung dienenden Bewegung ein periodisches Bezugssignal zu erzeugen, dessen Periode der Teilung des genannten zweiten Gitters entspricht und das mit der Bewegung des genannten Wagens synchronisiert ist, so daß es dem reinen periodischen Signal entspricht, welches von dem genannten photoelektrischen Sensor bei der Bewegung des Wagens erzeugt würde, wenn in der genannten Haltestellung dieses Wagens das genannte erste optische Gitter und das genannte zweite optische Gitter genau aufeinander ausgerichtet wären und wenn kein Störlicht dieses periodische Signal überlagern würde,

– Multiplikationsmittel (19), um in einer Vielzahl von aufeinanderfolgenden Zeitpunkten der genannten, der

6

EP 0 309 305 B1

Erfassung dienenden Bewegung daß Produkt aus den zusammengehörigen Werten des periodischen Bezugssignals und des tatsächlich von dem gennanten photoelektischen Sensor während dieser der Erfassung dienenden Bewegung gelieferten Signals zu bilden,

– Summierungsmittel (19), um während eines mindestens der Teilung des genannten zweiten Gitters entsprechenden Zeitspanne das von der Folge der durch die genannten Multiplikationsmittel gelieferten genannten Produkte gebildete Signal zu summieren,

– Rechenmittel (20), um aufgrund des integrierten Signals, welches von den genannten Summierungsmitteln geliefert wird, die Verschiebung zu bestimmen, welche gegebenenfalls zwischen dem genannten ersten optischen Gitter und dem genannten zweiten optischen Gitter besteht, wenn sich der Wagen in seiner Haltestellung befindet, sowie

– Mittel (16) zur Steuerung der Antriebsmittel (5), um den genannten Wagen (3) ausgehend von der genannten Haltestellung eine Korrekturbewegung ausführen zu lassen, deren Amplitude der genannten Verschiebung entspricht, um das genannte erste optische Gitter und das genannte zweite optische Gitter genau zur Deckung zu bringen, umfaßt.

2. Vorrichtung gemaäß Anspruch 1, dadurch gekennzeichnet, daß das genannte Bezugssignal sinusförming und/oder cosinusförmig ist.

3. Vorrichtung gemäß Anspruch 2, dadurch gekennzeichnet, daß die genannten Mittel, welche das genannte Bezugssignal erzeugen, gleichzeitig ein sinsusförmiges Bezugssignal und eine cosinuförmiges Bezugssignal erzeugen und die genannten Multiplikations- und Summierungsmittel die beiden integrierten, zusammengehörigen Signale bilden, so daß die genannten Rechenmittel die genannte Verschiebung aus dem Arkustangens des Verhältnisses der beiden integrierten Signale bestimmen.

4. Vorrichtung gemäß einem der Ansprüche 1 bis 3, dadurch gekennzeichnet, daß das genannte erste optische Gitter und/oder das genannte zweite optische Gitter Transmission-, Reflexions- oder Diffraktionsgitter sind.

5. Vorrichtung gemäß einem der Ansprüche 1 bis 3, dadurch gekennzeichnet, daß das genannte erste optische Gitter und/oder das genannte zweite optische Gitter Phasen- oder Amplitudengitter sind.

## Claims

1. Device for the precise positioning along an axis (OX) of an object (1), such as a wafer of semiconducting material during an integrated circuit manufacturing process, the said device comprising:

– a carriage (3) translationally movable along the said axis (OX) under the action of controlled motor means (5), the said object (1) being fixed to the carriage;

– a first optical grating (4) which is fixed, linear, periodic, parallel to the said axis and constituted by equidistant parallel bands perpendicular to the said axis;

– a second optical grating (10) which is linear, periodic and parallel to the said axis, integral with the said object (1) likewise constituted by equidistant parallel bands, the said object (1) being fixed to the said carriage (3) in such a manner that the bands of the second optical grating (10) are perpendicular to the said axis (OX) and the said first and second optical gratings being, at least approximately, optically aligned when the said carriage occupies a specified stop position;

– a light source (13) in order to illuminate the said first and second optical gratings (4 and 10); and

– a photoelectric sensor(14) in order to detect the light originating from the said optical gratings (4 and 10) ; characterised in that it comprises:

– means (15) for controlling the motor means (5) in order to cause the said carriage (3) to carry out, with respect to the said stop position, an acquisition displacement whose amplitude is at least equal to the spacing of the said second optical grating and then in order to bring the said carriage to the said stop position;

– means (18) for generating, during the said acquisition displacement, a periodic reference signal of period corresponding to the spacing of the said second grating and synchronised with the displacement of the said carriage, in such a manner as to correspond to the pure periodic signal which would be generated by the said photoelectric sensor during the displacement of the carriage in the case where, in the said stop position of the latter, the said first and second optical gratings would be precisely aligned and where no parasitic light ray would be superimposed with this periodic signal;

– multiplying means (19) in order to form, at a plurality of successive instants of the said acquisition displacement, the product of the corresponding values of the said periodic reference signal and of the signal actually supplied by the said photoelectric sensor during this acquisition displacement;

– adding means (19) in order to add, over a duration corresponding to at least the spacing of the said second grating, the signal formed by the succession of the said products supplied by the said multiplying means;

7

EP 0 309 305 B1

– calculating means (20) in order to determine, from the integrated signal supplied by the said adding means, the possible offset which exists between the said first and second optical gratings when the carriage is in its stop position; and

– means (16) for controlling the motor means (5) in order to cause the said carriage (3) to carry out, from the said stop position, a correction displacement whose amplitude corresponds to the said offset so as to bring the said first and second optical gratings into precise alignment.

2. Device according to Claim 1, characterised in that the said reference signal is sinusoidal and/or cosinusoidal.

3. Device according to Claim 2, characterised in that the said means generating the said reference signal generate both a sinusoidal reference signal and a cosinusoidal reference signal and the said multiplying and adding means form the two corresponding integrated signals, in such a manner that the said calculting means determine the said offset from the inverse tangent of the ratio of the said integrated signals.

4. Device according to one of Claims 1 to 3, characterised in that the said first and/or second optical gratings are of the transmission-, reflection- or diffraction-grating type.

5. Device according to Claims 1 to 3, characterised in that the said first and/or second optical gratings are of the phase- or amplitude-grating type.

8

## Fig.1

## Fig.2

## Fig.3

Fig.4a

Fig.4b

Fig.4c

Fig.4d

Fig.4e

Fig.4f